# EUROPÄISCHE PATENTSCHRIFT

(11) **EP 1 894 252 B1**
(45) Veröffentlichungstag und Bekanntmachung des Hinweises auf die Patenterteilung: **28.03.2018**
(21) Anmeldenummer: 06754882.6
(22) Anmeldetag: 27.04.2006
(51) Int. Cl.: H01L 29/78, H01L 21/336, H01L 27/02

(54) **MONOLITHISCH INTEGRIERTE HALBLEITERANORDNUNG MIT EINEM LEISTUNGSBAUELEMENT UND VERFAHREN ZUR HERSTELLUNG EINER MONOLITHISCH INTEGRIERTEN HALBLEITERANORDNUNG**
MONOLITHICALLY INTEGRATED SEMICONDUCTOR ASSEMBLY COMPRISING A POWER COMPONENT AND METHOD FOR PRODUCING A MONOLITHICALLY INTEGRATED SEMICONDUCTOR ASSEMBLY
DISPOSITIF A SEMI-CONDUCTEUR A INTEGRATION MONOLITHIQUE COMPRENANT UN COMPOSANT DE PUISSANCE, ET PROCEDE POUR REALISER UN DISPOSITIF A SEMI-CONDUCTEUR A INTEGRATION MONOLITHIQUE

(30) Priorität: 14.06.2005 DE 102005027366
(43) Veröffentlichungstag der Anmeldung: 05.03.2008
(73) Patentinhaber: ROBERT BOSCH GMBH, 70442 Stuttgart (DE)
(72) Erfinder: HEYKE, Klaus, 72770 Reutlingen (DE)
(86) Internationale Anmeldenummer: PCT/EP2006/061871
(87) Internationale Veröffentlichungsnummer: WO 2006/133995

(56) Entgegenhaltungen:
- DE-A1- 4 334 856
- DE-A1- 4 426 307
- AITKEN R C: "Test generation and fault modeling for stress testing" QUALITY ELECTRONIC DESIGN, 2002. PROCEEDINGS. INTERNATIONAL SYMPOSIUM ON 18-21 MARCH 2002, PISCATAWAY, NJ, USA,IEEE, 18. März 2002 (2002-03-18), Seiten 95-99, XP010589340 ISBN: 0-7695-1561-4

## Beschreibung

### Stand der Technik

Die Erfindung geht aus von einer monolithisch integrierten Halbleiteranordnung und einem Verfahren nach der Gattung der nebengeordneten Patentansprüche.

Aus der deutschen Offenlegungsschrift DE 43 34 856 A1 ist eine Anordnung zum Prüfen eines Gateoxids eines Powerbauelements bekannt, wobei trotz des Vorhandenseins einer zusammen mit dem Powerbauelement monolithisch integrierten Schaltung, die Überprüfung der Gateoxidqualität mit einer überhöhten Gateprüfspannung möglich ist. Hierzu ist vorgesehen, dass zwischen dem Gateoxid des Powerbauelements und der integrierten Schaltung eine Reihenschaltung aus einem ersten Messpad, einem Widerstand und einem zweiten Messpad angeordnet ist.

Bei Halbleiteranordnungen mit monolithisch integrierten Leistungsbauelementen ist es möglich, dass Anschlüsse, beispielsweise ein Gate-Anschluss eines MOS-Leistungstransistors, unterbrochen werden oder die Ansteuerung verloren geht (floating-gate-Zustand). Es kann in diesem Fall vorkommen, dass das Leistungsbauelement in den Zustand seiner maximalen Leistung geht, insbesondere wenn die Source-Drain-Spannung über einem Schwellenwert liegt. Hierdurch kommt es zu Ausfällen des Leistungsbauelementes sowie der gesamten Halbleiteranordnung, was zu schwerwiegenden Problemen und Folgeschäden führen kann, insbesondere dann, wenn das Leistungsbauelement und die dieses umfassende Halbleiteranordnung in einer sicherheitskritischen Komponente eines Fahrzeugs, insbesondere eines Kraftfahrzeugs angeordnet ist. Gleichzeitig ist jedoch zu gewährleisten, dass der möglicherweise unterbrochene Anschluss hinsichtlich seiner Betriebssicherheit überprüfbar ist, insbesondere ob im Falle eines Gate-Anschlusses bzw. einem mit dem Gate-Anschluss verbundenen Gateoxid, eine ausreichende Qualität, d. h. eine ausreichende Spannungsfestigkeit für die gesamte Lebensdauer des Leistungsbauelements gegeben ist.

### Vorteile der Erfindung

Die erfindungsgemäße monolithisch integrierte Halbleiteranordnung nach Anspruch 1, bzw. das Verfahren zur Herstellung einer monolithisch integrierte Halbleiteranordnung mit den Merkmalen des Anspruchs 8 hat demgegenüber den Vorteil, dass mit einfachen Mitteln sowohl eine Prüfbarkeit eines ersten Bereichs der Halbleiteranordnung möglich ist und das trotzdem sichergestellt werden kann, dass der erste Anschluss des Leistungsbauelementes in garantierter Weise ein Potential aufweist, welches nicht zu einer Zerstörung des Bauelements bzw. zu einer Zerstörung von weiteren Komponenten des Fahrzeuges führt. Bei einer Unterbrechung eines Gate-Anschlusses, wie sie beispielsweise durch einen Bondbruch hervorgerufen werden kann, oder auch bei einer verlorenen Ansteuerung eines Gate-Anschlusses eines Leistungsbauelements, insbesondere eines MOS-FET- Transistors kann ein solches Leistungsbauelement in den Zustand maximaler Leistung gehen. Eine Lösung dies zu verhindern wäre das Vorsehen eines Widerstandes zwischen dem Gate-Anschluss und dem Sourceanschluss des MOS-FET- Transistors. Bei einem bereits bei der Herstellung der Halbleiteranordnung eingebrachten solchen Widerstand wäre es nicht möglich, das Gateoxid bzw. das am Gate-Anschluss angeordnete Dielektrikum des MOS-FET-Transistors in zuverlässiger Weise zu prüfen, da eine Störung des Gateoxids nicht mehr zuverlässig detektiert werden kann, weil über den Widerstand ein zu großer Strom fließen würde, so dass die kleinen, durch die Dielektrikumschicht hindurchfließenden und bei einer Prüfung des Gateoxids zu detektieren Ströme überdeckt werden würden. Es war für einen Fachmann überaus überraschend, dass es möglich ist, beide Zielsetzungen mit einfachen Mitteln dadurch zu erreichen, dass zwar eine Widerstandsstruktur in Form eines Widerstandselements zwischen dem ersten Anschluss und dem zweiten Bereich eines Leitungsbauelementes vorgesehen wird, wobei ein solches Widerstandselement jedoch zunächst noch keine Funktion entfaltet, sondern anschließend durch den ersten Bereich hindurch mit dem zweiten Bereich verbunden ist. Dies ist erfindungsgemäß bevorzugt durch einen ersten und zweiten Teilbereich des ersten Bereichs möglich, wobei der erste Bereich in seinem zweiten Teilbereich degeneriert ist. Dies erfolgt erfindungsgemäß bevorzugt durch das Anlegen eines Spannungsimpulses. In einem zweiten Teilbereich des ersten Bereichs, d. h. innerhalb der Dielektrikumschicht, wird hierbei ein niederohmiger Teilbereich erzeugt, der das Widerstandselement in Betrieb setzt.

Ein solches Verhalten kann mittels eines monolithisch integrierten Widerstandselementes erreicht werden, welches zwischen dem ersten Anschluss und dem zweiten Bereich vorgesehen ist und wobei zwischen dem Widerstandselement und dem zweiten Bereich im zweiten Teilbereich des ersten Bereichs eine vergleichsweise niederohmige elektrische Verbindung durch den ersten Bereich hindurch vorgesehen ist. Vorteilhaft ist, dass eine solche vergleichsweise niederohmige elektrische Verbindung mit einfachen Mitteln auch nach der eigentlichen Herstellung der Halbleiteranordnung bzw. des Leistungsbauelementes, insbesondere mittels eines Überspannungsimpulses herbeiführbar ist. Bevorzugt ist ferner, dass im ersten Teilbereich einerseits des ersten Bereichs der erste Anschluss und andererseits des ersten Bereichs eine Kanalzone vorgesehen ist, so dass mit einfachen Mitteln vorteilhaft ein MOS-FET-Leistungstransistor als Leistungsbauelement Verwendung finden kann. Ferner ist bevorzugt, dass angrenzend an den zweiten Teilbereich eine Kontaktfläche, beispielsweise ein Messpad, für einen weiteren Anschluss vorgesehen ist. Hierdurch kann der Überspannungsimpuls oder Überspannungsstoß mit einfachen Mitteln eingebracht werden, so dass zum einen für das Einbringen des Überspannungsimpulses vergleichsweise wenig Aufwand betrieben werden muss und dass zum anderen ein effektiver Schutz der übrigen Bereiche der Halbleiteranordnung gewährleistet ist. Es ist ferner bevorzugt, dass das Leistungsbauelement ein MOS-Leistungstransistor ist, insbesondere ein vertikaler MOS-Leistungstransistor. Hierdurch ist es besonders kostengünstig möglich, auf bestehende Fertigungstechnologie aufzubauen um die erfindungsgemäße Halbleiteranordnung herzustellen. Ferner ist bevorzugt, dass der erste Anschluss den Gate-Anschluss des Leistungsbauelementes entspricht und dass der zweite Anschluss dem Sourceanschluss entpricht. Ferner ist es weiterhin bevorzugt, dass der erste Bereich eine Halbleiteroxidschicht, insbesondere Siliziumoxidschicht, ist. Hierdurch kann mit etablierter Prozesstechnologie in besonders sicherer und kostengünstiger Weise eine Schicht aus einem Dielektrikum hergestellt werden, so dass die erfindungsgemäße Halbleiteranordnung den Lebensdaueranforderungen für den vorgesehen Einsatzzweck, insbesondere im Automobilbereich, erfüllt.

Ein weiterer Gegenstand der vorliegenden Erfindung ist ein Verfahren zur Herstellung einer erfindungsgemäßen monolithisch integrierten Halbleiteranordnung, wobei zunächst die Halbleiteranordnung im Wesentlichen vollständig hergestellt wird, insbesondere das Leistungsbauelement im Wesentlichen vollständig hergestellt wird, wobei in einem zweiten Schritt der zweite Teilbereich des ersten Bereichs derartig generiert wird, dass der zweite Teilbereich niederohmig wird. Optional ist es möglich, zwischen dem ersten Schritt und dem zweiten Schritt eine Prüfung des ersten Bereichs derart vorzusehen, dass Halbleiteranordnungen, deren erster Bereich die geforderten Spezifikationen nicht erreichen, ausgesondert werden.

### Zeichnungen

Ein Ausführungsbeispiel der Erfindung ist in der Zeichnung dargestellt und in der nachfolgenden Beschreibung näher erläutert.

Es zeigen
**Figur 1** ein schematisches Schaltbild einer Halbleiteranordnung nach dem ersten Schritt und vor dem zweiten Schritt des erfindungsgemäßen Verfahrens zur Herstellung der Halbleiteranordnung,
**Figur 2** ein schematisches Schaubild der erfindungsgemäßen Halbleiteranordnung nach dem zweiten Schritt des Verfahrens zur Herstellung der Halbleiteranordnung,
**Figur 3** ein schematisches Schaltbild einer weiteren Ausführungsform der erfindungsgemäßen Halbleiteranordnung und
**Figur 4** eine schematische Darstellung des Aufbaus der erfindungsgemäßen monolithisch integrierten Halbleiteranordnung.

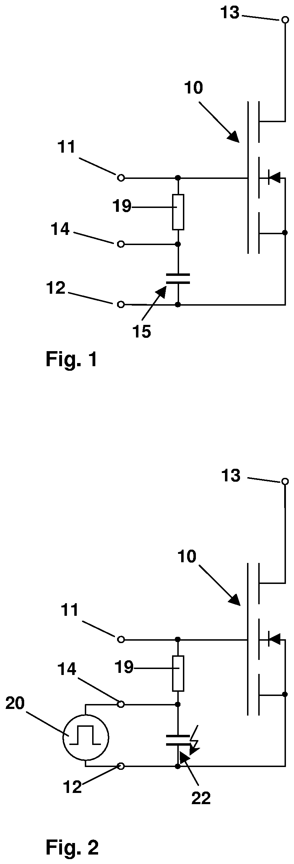

**In** **Figur 1** ist eine schematische Schaltungsanordnung einer Halbleiteranordnung dargestellt. Die Halbleiteranordnung umfasst ein Leistungsbauelement 10, welches insbesondere als Leistungstransistor 10 ausgelegt ist, insbesondere als MOS-FET-Transistor bzw. Power-MOS-Transistor. Das Leistungsbauelement 10 weist einen ersten Anschluss 11 einen zweiten Anschluss 12 und einen dritten Anschluss 13 auf. Die vorliegende Erfindung ist anhand eines MOS-FET-Leitungstransistors als Beispiel eines Leistungsbauelementes 10 dargestellt. Dies ist jedoch nur beispielhaft zu verstehen. Erfindungsgemäß können andere Arten von Leistungsbauelementen, beispielsweise Thyristoren oder dergleichen, welche gegebenenfalls auch mehr als drei Anschlüsse aufweisen, erfindungsgemäß Verwendung finden. Zwischen dem ersten Anschluss 11 und einem in Figur 1 nicht dargestellten zweiten Bereich des Leistungsbauelementes 10 ist erfindungsgemäß ein Widerstandselement 19 angeordnet. Der zweite Bereich ist hierbei elektrisch mit dem zweiten Anschluss 12 verbunden, wodurch sich in der Schaltungsdarstellung in der Figur 1 eine Verbindung zwischen dem Widerstandselement 19 und dem zweiten Anschluss 12 ein elektrisch isolierendes Gebiet ergibt, d.h. zwischen dem Widerstandselement 19 und dem zweiten Anschluss 12 ist ein erster Bereich 15 des Leistungsbauelements 10 angeordnet, welcher das Widerstandselement 19 zunächst von dem zweiten Anschluss 12 elektrisch trennt bzw. in Form im Wesentlichen eines Kondensators, vorgesehen ist. Zwischen dem Widerstandselement 19 und dem zweiten Anschluss 12 ist in Figur 1 noch ein weiterer Anschluss 14 dargestellt.

**In** **Figur 2** ist die schematische Anordnung der erfindungsgemäßen Halbleiteranordnung dargestellt, wobei das Leistungsbauelement 10 wiederum den ersten Anschluss 11, den zweiten Anschluss 12 und den dritten Anschluss 13 aufweist. Weiterhin weist das Leistungsbauelement 10 wiederum das Widerstandselement 19 auf. Aus Figur 2 wird deutlich, dass mittels eines zwischen dem zweiten Anschluss 12 und einem weiteren Anschluss 14 angelegten Überspannungsimpulses 20 der erste Bereich 15 (vergleiche Figur 1) in einem Teilbereich derart degeneriert werden kann, dass es zu einer elektrisch niederohmigen Verbindung zwischen dem Widerstandselement 19 und dem zweiten Anschluss 12 kommt. Dies ist in Figur 2 mittels eines Blitzzeichens an der Kondensatorstruktur 22 dargestellt. Mit dem Bezugszeichen 22 ist hierbei ein zweiter Teilbereich des ersten Bereichs 15 gezeichnet, welcher durch den Überspannungsimpuls 20 niederohmig geworden ist.

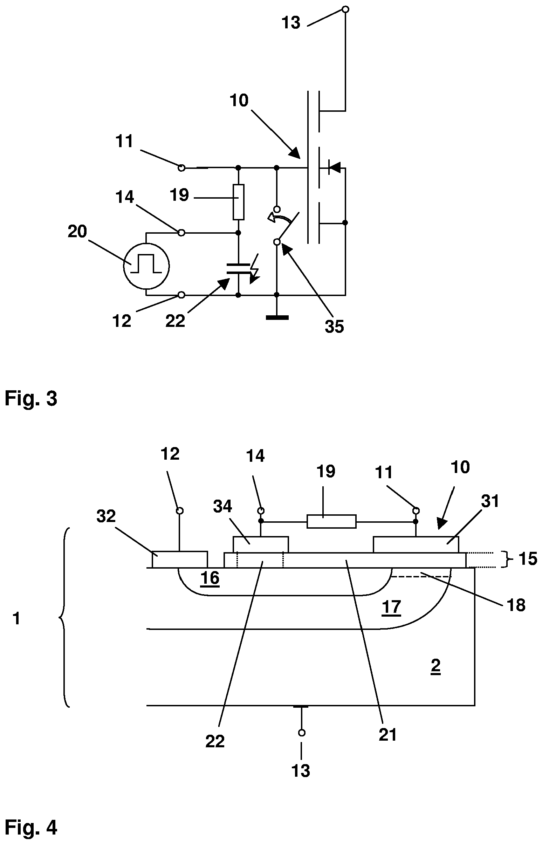

**In** **Figur 3** ist eine schematische Schaltungsdarstellung der Halbleiteranordnung in einer alternativen Ausführungsformen dargestellt. Das Leistungsbauelement 10 weist wiederum den ersten Anschluss 11, den zweiten Anschluss 12, den dritten Anschluss 13 und den weiteren Anschluss 14 auf. Zwischen dem ersten Anschluss 11 und dem zweiten Anschluss 12 sind in Figur 3 das Widerstandselement 19 und der zweite Teilbereich 22 des ersten Bereichs 15 angeordnet, wobei der Überspannungsimpuls 20 bewirkt, dass der zweite Teilbereich 22 niederohmig degeneriert ist. Zum Schutz des Leistungsbauelementes 10 kann ferner während des Überspannungsimpulses 20 zwischen dem ersten Anschluss 11 und dem zweiten Anschluss 12 ein Kurzschluss hergestellt werden, was in der Figur 3 mittels eines angedeuteten Schalters 35 dargestellt ist.

**In** **Figur 4** ist die monolithisch integrierte erfindungsgemäße Halbleiteranordnung 1 mit dem Leistungsbauelement 10 in einer Schnittdarstellung schematisch dargestellt. Als Leistungsbauelement 10 ist erfindungsgemäß insbesondere ein vertikaler MOS-FET-Transistor 10 vorgesehen. Ein solcher weist in einem Substratmaterial 2, insbesondere Halbleitermaterial, besonders bevorzugt Siliziummaterial, mehrere Wannen bzw. mehrere Bereich unterschiedlicher Dotierung auf. So ist ein zweiter (bevorzugt negativ dotierter) Bereich 16 innerhalb eines dritten (bevorzugt positiv dotierten) Bereichs 17 angeordnet. Oberhalb des Dritten Bereichs 17 ist der erste Bereich 15 insbesondere in Form einer Schicht aus vergleichsweise hochohmigem Material, vorzugsweise ein Dielektrikummaterial wie beispielsweise Siliziumoxid, Siliziumnitrid, allgemein Halbleiteroxid bzw. Halbleiternitrid oder dergleichen ausgebildet. Oberhalb des ersten Bereichs 15, welcher auch als Gateoxid 15 bezeichnet wird, ist im Bereich der Verbindung zwischen dem ersten Bereich 15 und dem dritten Bereich 17 eine erste Anschlussfläche 31 oder erste Anschlusselektrode 31 zu Realisierung des ersten Anschlusses 11 vorgesehen. Die erste Anschlusselektrode 31 ist erfindungsgemäß insbesondere als Anschlussmetallisierung (Kontaktpad) ausgeführt. Oberhalb des zweiten Bereichs 16 ist eine zweite Anschlussfläche 32 vorgesehen, welche den zweiten Anschluss 12 realisiert. Auf der Rückseite des Substratmaterials 2 ist der dritte Anschluss 13 des Leistungsbauelements 10 realisiert, wobei erfindungsgemäß bevorzugt ebenfalls eine Anschlussmetallisierung zur Realisierung einer Anschlusselektrode vorgesehen ist.

In bekannter Weise funktioniert das Leistungsbauelement 10 in Form eines MOS-FET Transistors derart, dass sich ein Kanal 18 im dritten Bereich 17 des Leistungsbauelementes 10 zwischen dem zweiten Bereich 16 und dem Substratmaterial 2 an der Stelle ausbildet, die dem ersten Anschluss 11 (durch das Gateoxid 15 bzw. durch den ersten Bereich 15 getrennt) gegenüberliegt. Erfindungsgemäß ist es nun vorgesehen, dass im Bereich des ersten Bereichs 15, bevorzugt oberhalb des ersten Bereichs 15, das Widerstandselement 19 zwischen dem ersten Anschluss 11 und dem weiteren Anschluss 14 zunächst elektrisch vom zweiten Bereich 16 durch den ersten Bereich 15 getrennt vorgesehen ist. Erfindungsgemäß ist bevorzugt, dass der weitere Anschluss 14 mittels einer weiteren Anschlussfläche 34 auf dem ersten Bereich 15 realisiert ist. Das Widerstandselement 19 ist erfindungsgemäß bevorzugt mittels einer Polysiliziumsstruktur realisiert, bevorzugt mittels einer mäanderförmigen Polysiliziumstruktur. Andere Strukturen zur Realisierung des Widerstandselementes 19 sind jedoch ebenfalls möglich.

Es ist nun vorgesehen, dass der erste Bereich 15, d. h. das Gateoxid 15 durchgängig sowohl unterhalb des ersten Anschlusses 11 als auch unterhalb des weiteren Anschlusses 14 zunächst intakt ist, d. h. eine isolierende Wirkung aufweist. Das Leistungsbauelement 10 bzw. die Halbleiteranordnung 10 kann hierbei vollständig fertig prozessiert sein bzw. vorliegen. Alternativ ist es auch möglich, dass die monolithisch integrierte Halbleiteranordnung noch nicht vollständig fertig gestellt ist, jedoch die in der Figur 4 dargestellten Bereich bereits existieren bzw. auch mittels nicht dargestellter Passivierungsschichten zumindest teilweise abgedeckt sind. Es schließt sich hier erfindungsgemäß ein Prüfungsschritt des Dielektrikums im ersten Bereich 15 an. Es ist nämlich so, dass das Dielektrikum 15 bzw. der erste Bereich 15 zwischen dem dritten Bereich 17 und dem ersten Anschluss 11 für den Betrieb des Leistungsbauelementes 10 über die gesamte Labensdauer der Anordnung, welche der Lebensdauer eines Fahrzeugs entsprechen soll, d. h. etwa 10 bis 15 oder sogar mehr Jahre betragen soll, eine kritische Stelle ist. Störstellen bzw. andere Fehler innerhalb des ersten Bereichs 15 bewirken, dass die Durchschlagsfestigkeit in diesem Bereich nicht ausreichend groß ist, was vor allem im Laufe der Lebensdauer des Bauelementes bzw. der Halbleiteranordnung zu Ausfällen führt, die nicht nur das gesamte Bauelement bzw. die gesamte Halbleiteranordnung, sondern darüber hinaus noch Schäden an hiermit verbundenen Komponenten verursachen kann. Das Widerstandselement 19 ist erfindungsgemäß derart niederohmig, dass beispielsweise ein Bondbruch am ersten Anschluss 11 nicht dazu führt, dass ein sogenannter Floating-Gate-Zustand eingenommen wird, d.h. ein Zustand, bei dem der erste Anschluss 11 auf keinem definierten Potential liegt. In diesem Fall eines ausreichende niederohmigen Widerstandselements 19, um diese Funktionalität zu erfüllen, ist es jedoch so, dass eine Prüfungsmöglichkeit des ersten Bereichs 15 zu Überprüfung der Durchschlagfestigkeit nicht mehr im erforderlichen Maß möglich ist, weil durch die relative Niederohmigkeit des Widerstandselements 19 bei der Prüfung ein zu großer Strom über dieses Widerstandselement 19 fließen würde. Hierbei ist zu berücksichtigen, dass die Prüfung des ersten Bereichs 15, d. h. die Prüfung des Gateoxides 15 mit einer Messung von durch das Gateoxid fließenden Strömen im Pikoamperbereich verbunden ist, wohingegen bei den auftretenden Prüfspannungen von bis zu 60 V allein durch das Widerstandselement 19 Ströme fließen würden, die um mehrere Größenordnungen darüber liegen. Daher wird erfindungsgemäß vorgeschlagen, dass das Widerstandselement 19 zunächst isoliert vom zweiten Bereich 16 vorgesehen ist, wobei als Isolierungsmaterial der erste Bereich 15 vorgesehen ist. Durch den Überspannungsimpuls 20 zwischen den beiden Anschlüssen und dem weiteren Anschluss 14 ist es erfindungsgemäß möglich, den ersten Bereich 15 in dem ersten Teilbereich 21 und den zweiten Teilbereich 22 aufzuspalten, wobei der erste Teilbereich weiterhin ausreichend hochohmig ist, um über die gesamte Lebensdauer des Bauelementes dessen Funktionalität zu gewährleisten und wobei der zweite Teilbereich 22 ausreichend niederohmig ist, um das Widerstandselement 19 an den zweiten Anschluss 12 elektrisch anzuschließen. Beispielhaft sei folgendes Prüfszenario angeführt: Bei einer Prüfspannung von ±15V liegen die Gateoxidströme bei intaktem Gateoxid physikalisch begründet im pA-Bereich. In einem Wafertestprogramm wird das Gateoxid beispielsweise mit positiver und negativer maximaler Gatespannung geprüft, wobei die fließenden Ströme unterhalb von 100 nA bleiben müssen, damit das Gateoxid als funktionsfähig und zuverlässig angesehen wird. Wenn der Widerstandswert des Widerstandselements 19 beispielsweise 15 Kiloohm beträgt, ergibt sich bei 15 V angelegter Spannung ein Fehlstrom von 1 mA, so dass der Fehlstrom jedenfalls vier Größenordnungen über dem maximal zulässigen durch das Gateoxid fließenden Strom liegt.

## Patentansprüche

1. Monolithisch integrierte Halbleiteranordnung (1) mit einem Leistungsbauelement (10), wobei das Leistungsbauelement (10)
- einen ersten Bereich (15) eines Dielektrikums und oberhalb des ersten Bereichs (15) einen ersten Anschluss (11) aufweist, und
- einen zweiten Bereich (16) eines dotierten Halbleitermaterials und einen mit dem zweiten Bereich (16) elektrisch verbundenen zweiten Anschluss (12) aufweist,
wobei zwischen dem ersten Anschluss (11) und dem zweiten Bereich (16) ein monolithisch integriertes Widerstandselement (19) angeordnet ist,
**dadurch gekennzeichnet dass**
zwischen dem Widerstandselement (19) und dem zweiten Bereich (16) ein zweiter Teilbereich (22) durch den ersten Bereich (15) hindurch ausgebildet ist, der eine vergleichsweise niederohmige elektrische Verbindung darstellt.

2. Halbleiteranordnung (1) nach Anspruch 1, **dadurch gekennzeichnet, dass** der erste Bereich (15) einen ersten hochohmigen Teilbereich (21) aufweist, wobei im zweiten Teilbereich (22) eine Degenerierung der elektrisch isolierenden Eigenschaft des ersten Bereichs (15) vorhanden ist.

3. Halbleiteranordnung (1) nach Anspruch 2, **dadurch gekennzeichnet, dass** der erste Anschluss (11) oberhalb des_ersten Teilbereichs (21) des ersten Bereichs (15) angeordnet ist, wobei auf der dem ersten Anschluss (11) gegenüberliegenden Seite des ersten Bereichs (15) eine durch den ersten Bereich (15) getrennte Kanalzone (18) ausgebildet ist.

4. Halbleiteranordnung (1) nach Anspruch 2 oder 3, **dadurch gekennzeichnet, dass** angrenzend an den zweiten Teilbereich (22) eine Kontaktfläche für einen weiteren Anschluss (14) vorhanden ist.

5. Halbleiteranordnung (1) nach einem der vorhergehenden Ansprüche, **dadurch gekennzeichnet, dass** das Leistungsbauelement (10) ein MOS-Leistungstransistor ist, insbesondere ein vertikaler MOS-Leistungstransistor.

6. Halbleiteranordnung (1) nach einem der vorhergehenden Ansprüche, **dadurch gekennzeichnet, dass** der erste Anschluss (11) dem Gate-Anschluss des Leistungsbauelements (10) entspricht und dass der zweite Anschluss (12) dem Source-Anschluss entspricht.

7. Halbleiteranordnung (1) nach einem der vorhergehenden Ansprüche, **dadurch gekennzeichnet, dass** der erste Bereich (15) eine Halbleiteroxidschicht, insbesondere Siliziumoxidschicht, ist.

8. Verfahren zur Herstellung einer Halbleiteranordnung (1) gemäß einem der vorhergehenden Ansprüche, **dadurch gekennzeichnet, dass** in einem ersten Schritt die Halbleiteranordnung (1) mit dem ersten Bereich (15) derart hergestellt wird, dass der erste Bereich (15) durchgängig hochohmig ist und dass in einem zweiten Schritt der zweite Teilbereich (22) derart degeneriert wird, dass der zweite Teilbereich (22) niederohmig wird, wobei die Degenerierung insbesondere durch einen Überspannungsstoß hervorgerufen wird.

## Claims

1. Monolithically integrated semiconductor arrangement (1) comprising a power component (10), wherein the power component (10)
- comprises a first region (15) of a dielectric and a first terminal (11) above the first region (15), and
- comprises a second region (16) of a doped semiconductor material and a second terminal (12), which is electrically connected to the second region (16),
wherein a monolithically integrated resistance element (19) is arranged between the first terminal (11) and the second region (16),
**characterized in that**
between the resistance element (19) and the second region (16) a second partial region (22) is formed through the first region (15), which constitutes a comparatively low-impedance electrical connection.

2. Semiconductor arrangement (1) according to Claim 1, **characterized in that** the first region (15) comprises a first high-impedance partial region (21) wherein a degeneration of the electrically insulating property of the first region (15) is present in the second partial region (22).

3. Semiconductor arrangement (1) according to Claim 2, **characterized in that** the first terminal (11) is arranged above the first partial region (21) of the first region (15), wherein a channel zone (18) separated by the first region (15) is formed on the opposite side of the first region (15) with respect to the first terminal (11).

4. Semiconductor arrangement (1) according to Claim 2 or 3, **characterized in that** a contact pad for a further terminal (14) is present in a manner adjoining the second partial region (22).

5. Semiconductor arrangement (1) according to any of the preceding claims, **characterized in that** the power component (10) is a MOS power transistor, in particular a vertical MOS power transistor.

6. Semiconductor arrangement (1) according to any of the preceding claims, **characterized in that** the first terminal (11) corresponds to the gate terminal of the power component (10), and **in that** the second terminal (12) corresponds to the source terminal.

7. Semiconductor arrangement (1) according to any of the preceding claims, **characterized in that** the first region (15) is a semiconductor oxide layer, in particular silicon oxide layer.

8. Method for producing a semiconductor arrangement (1) according to any of the preceding claims, **characterized in that**, in a first step, the semiconductor arrangement (1) is produced with the first region (15) in such a way that the first region (15) has high impedance throughout, and **in that**, in a second step, the second partial region (22) is degenerated in such a way that the second partial region (22) acquires low impedance, wherein the degeneration is brought about in particular by an overvoltage surge.

## Revendications

1. Arrangement semiconducteur (1) intégré monolithique comprenant un composant de puissance (10), le composant de puissance (10)
- possédant une première zone (15) d'un diélectrique et une première borne (11) au-dessus de la première zone (15), et
- possédant une deuxième zone (16) d'un matériau semiconducteur dopé et une deuxième borne (12) reliée électriquement à la deuxième zone (16),
un élément résistif (19) intégré monolithique étant disposé entre la première borne (11) et la deuxième zone (16),
**caractérisé en ce que**
une deuxième zone partielle (22) est formée à travers la première zone (15) entre l'élément résistif (19) et la deuxième zone (16), laquelle représente une liaison électrique à relativement faible impédance.

2. Arrangement semiconducteur (1) selon la revendication 1, **caractérisé en ce que** la première zone (15) possède une première zone partielle (21) à haute impédance, une dégénérescence de la propriété électriquement isolante de la première zone (15) étant présente dans la deuxième zone partielle (22).

3. Arrangement semiconducteur (1) selon la revendication 2, **caractérisé en ce que** la première borne (11) est disposée au-dessus de la première zone partielle (21) de la première zone (15), une zone de canal (18) séparée par la première zone (15) étant formée sur le côté de la première zone (15) qui se trouve à l'opposé de la première borne (11).

4. Arrangement semiconducteur (1) selon la revendication 2 ou 3, **caractérisé en ce qu'**une surface de contact pour une borne supplémentaire (14) est adjacente à la deuxième zone partielle (22).

5. Arrangement semiconducteur (1) selon l'une des revendications précédentes, **caractérisé en ce que** le composant de puissance (10) est un transistor de puissance MOS, notamment un transistor de puissance MOS vertical.

6. Arrangement semiconducteur (1) selon l'une des revendications précédentes, **caractérisé en ce que** la première borne (11) correspond à la borne de gâchette du composant de puissance (10) et **en ce que** la deuxième borne (12) correspond à la borne de source.

7. Arrangement semiconducteur (1) selon l'une des revendications précédentes, **caractérisé en ce que** la première zone (15) est une couche d'oxyde de semiconducteur, notamment une couche d'oxyde de silicium.

8. Procédé de fabrication d'un arrangement semiconducteur (1) selon l'une des revendications précédentes, **caractérisé en ce qu'**au cours d'une première étape, l'arrangement semiconducteur (1) avec la première zone (15) est fabriqué de telle sorte que la première zone (15) est entièrement à haute impédance, et **en ce qu'**au cours d'une deuxième étape, la deuxième zone partielle (22) est générée de telle sorte que la deuxième zone partielle (22) devient à basse impédance, la dégénérescence étant notamment provoquée par un choc de surtension.
